# EUROPEAN PATENT APPLICATION

(11) **EP 4 697 873 A1**
(43) Date of publication of application: **18.02.2026**
(21) Application number: 25183252.3
(22) Date of filing: 17.06.2025
(51) Int. Cl.: H05K 7/14, H05K 7/20

(54) **WATER-COOLED CONTAINER SYSTEM**

(30) Priority: 18.06.2024 CN 202421389529 U
(71) Applicant: Straitdeer Pte. Ltd., Singapore 339509 (SG)
(72) Inventor: LIAO, WANG, 339509 Singapore (SG); LIANG, CHAO, 339509 Singapore (SG); LIU, HAIQUAN, 339509 Singapore (SG); YANG, QINGYAN, 339509 Singapore (SG); WANG, JIAN, 339509 Singapore (SG); XIA, YU, 339509 Singapore (SG); REN, GUIHONG, 339509 Singapore (SG)
(74) Representative: Metida

(57) **Abstract**

Disclosed is a water-cooled container system. The water-cooled container system includes a data processing device, a water cooling apparatus, a power supply device, and a power distribution cabinet. The water cooling apparatus is configured to accommodate the data processing device and to dissipate heat for the data processing device. The power supply device is at least configured to supply power to the data processing device. The water cooling apparatus includes a water cooling cabinet, a water inlet pipe, a water outlet pipe, a control device, and a cooling device. The water-cooled container system has a cuboid body, and a space enclosed by an outer contour of the water-cooled container system is divided by a water barrier plate having a notch into a first space and a second space. The control device is arranged in the first space.

## Description

### TECHNICAL FIELD

The present disclosure relates to the technical field of data processing, and in particular, relates to a water-cooled container system.

### BACKGROUND

With the rise and development of industries such as Internet virtual assets and artificial intelligence, the demands on data processing capabilities of data processing devices are becoming increasingly stringent. To enhance the computing power of the data processing devices, the scale of hardware infrastructure thereof is continuously expanding, operating time is being prolonged, and thus power consumption is increasing. Consequently, when the data processing devices operate for extended periods, the operating temperature gradually rises. This leads to accelerated aging of hardware components and an increased rate of malfunctions.

To reduce the operating temperature of the data processing devices, in the related arts, cooling systems are typically employed. Common cooling solutions include wind cooling, water cooling, and oil cooling systems. In areas with abundant water resources, water cooling is a preferred cooling method for data processing devices. However, as data processing devices contain a large number of electronic components, the data processing devices are prone to malfunctions responsive to coming into contact with water. In conventional systems, data processing devices and cooling devices are often integrated together. For example, within the internal space of a container, while servers (which are part of the data processing device) are housed, components such as water pumps controlling water inflow and outflow, and power distribution cabinets for the data processing device are also typically placed at the ends of the servers or in close proximity. Consequently, where components like water pumps malfunction and spray water, failures are easily caused to the data processing device, and the overall safety of the device is poor.

### SUMMARY

In view of the above, the present disclosure is mainly intended to provide a water-cooled container system that achieves a higher safety level.

To achieve the above objective, the present disclosure employs the following technical solutions:

Embodiments of the present disclosure provide a water-cooled container system. The water-cooled container system includes a data processing device, a water cooling apparatus, a power supply device, and a power distribution cabinet, wherein the water cooling apparatus is configured to accommodate the data processing device and to dissipate heat for the data processing device, and the power supply device is at least configured to supply power to the data processing device;
wherein the water cooling apparatus includes a water cooling cabinet, a water inlet pipe, a water outlet pipe, a control device, and a cooling device; the data processing device is accommodated in the water cooling cabinet, one end of each of the water inlet pipe and the water outlet pipe is connected to the water cooling cabinet, and the other end of the each of the water inlet pipe and the water outlet pipe is connected to the control device; and the control device is configured to control water to flow from the water inlet pipe into the water cooling cabinet, wherein the water absorbs heat generated by the data processing device during running, then flows out from the water outlet pipe, and is re-fed into the water inlet pipe after being cooled by the cooling device; and
wherein the water-cooled container system has a cuboid body, and a space enclosed by an outer contour of the water-cooled container system is divided by a water barrier plate having a notch into a first space and a second space; wherein the control device is arranged in the first space; the water cooling cabinet and the power distribution cabinet are arranged in the second space, and the power distribution cabinet is arranged on a side of the water cooling cabinet away from the control device; and the water inlet pipe and the water outlet pipe in the first space pass through the notch of the water barrier plate to enter the second space.

In some embodiments, the notch is arranged in a corner of a top portion of the water barrier plate;
a recess extending in a vertical direction is arranged in the water barrier plate; and
a cross-section of the water barrier plate is wave-shaped, and a distance between the power distribution cabinet and the control device is greater than 4 meters.

In some embodiments, each of the first space and the second space has a cuboid body shape;
the second space is relatively sealed and is cooperatively enclosed by a plurality of panels and the water barrier plate; and
a top panel and a bottom panel are respectively arranged at a top portion and a bottom portion of the first space, and the first space has a two-sided openwork structure, or a three-sided openwork structure, or an open structure.

In some embodiments, a plurality of the water cooling cabinets are provided, and the water cooling cabinets are closely arranged along a first direction;
wherein each of the water cooling cabinets includes, in a second direction, a first side and a second side that are opposite to each other, the water inlet pipe and the water outlet pipe are connected to each of the water cooling cabinets from the first side, and wirings from the power distribution cabinet enter each of the water cooling cabinets from the second side to supply power to the data processing device;
wherein the second direction is perpendicular to the first direction.

In some embodiments, a plurality of the water cooling cabinets are provided and are arranged along a first direction; and the water-cooled container system is symmetrically designed with respect to a centerline in the first direction as an axis of symmetry.

In some embodiments, a plurality of the water cooling cabinets are provided, and the water cooling cabinets are closely arranged along a first direction to form a water cooling cabinet group;
a plurality of water cooling cabinet groups are accommodated in the second space, wherein the plurality of water cooling cabinet groups are arranged along the first direction, and the power distribution cabinet is arranged at a middle position among the plurality of water cooling cabinet groups; and
the space enclosed by the outer contour of the water-cooled container system is divided by two said water barrier plates having notches into two said first spaces and the second space, wherein the two first spaces are disposed at opposite ends of the second space, the control device is arranged in each of the two first spaces, and the control device is configured to control water to be conveyed to the water cooling cabinets via the water inlet pipe and the water outlet pipe.

In some embodiments, a plurality of the water cooling cabinets are provided, and the water cooling cabinets are closely arranged along a first direction; and
the water inlet pipe includes a main water inlet pipe and branch water inlet pipes, wherein the main water inlet pipe is configured to convey water to each of the water cooling cabinets via the branch water inlet pipes; and the water outlet pipe includes a main water outlet pipe and branch water outlet pipes, wherein each of the water cooling cabinets is configured to convey water to the main water outlet pipe via the branch water outlet pipes;
wherein the main water inlet pipe and the main water outlet pipe extend along the first direction, and the main water inlet pipe and the main water outlet pipe are offset from the water cooling cabinets in a second direction; and
wherein a cable rack is arranged on a top portion of an end of each of the water cooling cabinets away from the water inlet pipe or the water outlet pipe in the second direction, and a cable routing hole is arranged in a top portion of the each of the water cooling cabinets;
wherein the first direction is perpendicular to the second direction.

In some embodiments, the control device includes a water pump, a deaeration tank, and a water replenishment tank, wherein the water pump is arranged on a pipeline of the water inlet pipe, and the deaeration tank and the water replenishment tank are arranged on a pipeline of the water outlet pipe.

In some embodiments, the data processing device includes servers and network switches; wherein a number of chips connected in series on a hash board included in each of the servers is greater than one hundred;
the water-cooled container system further includes power distribution units (PDUs) for power supply, wherein the PDUs are connected to the power distribution cabinet; and
the water cooling cabinet includes a first mounting space and a second mounting space juxtaposed in a horizontal direction, a plurality of the servers are stacked and secured in the first mounting space, and the PDUs are secured in the second mounting space;
wherein the PDUs are arranged on one side of each of the servers, and the first mounting space and the second mounting space are in communication in the horizontal direction.

In some embodiments, a plurality of the water cooling cabinets are provided, and the water cooling cabinets are closely arranged along a first direction to form a water cooling cabinet group;
the water-cooled container system includes, in a direction perpendicular to the first direction, a first main panel and a second main panel that are opposite to each other, wherein and an aisle is arranged between the water cooling cabinet group and the first main panel, and an aisle is arranged between the water cooling cabinet group and the second main panel;
wherein a door is arranged in each of the first main panel and the second main panel.

In the water-cooled container system according to the present disclosure, because the water barrier plate separates the water cooling cabinet accommodating the data processing device and the power distribution cabinet from the control device into different spaces, even though a fault occurs in the control device and thus water is caused to flow out, the data processing device and the power distribution cabinet are not affected. In this way, the waterproof performance of the water-cooled container system is improved, and the safety is greatly enhanced. In addition, since the power distribution cabinet is arranged on a side of the water cooling cabinet away from the control device, the power distribution cabinet is far away from the control device, that is, outside the water paths. Even though leakage occurs, the likelihood that power distribution cabinet is affected is significantly reduced. Furthermore, the power distribution cabinet and the control device are respectively disposed at opposite ends relative to the water cooling cabinet, such that gravity distribution of the water-cooled container system is uniform, thereby facilitating hoisting, transportation, and stable placement.

Other beneficial effects of the present disclosure are described in retail with reference to specific technical features and technical solutions in the specific embodiments. A person skilled in the art may understand the beneficial effects achieved by these technical features and technical solutions through description of these technical features and technical solutions.

### BRIEF DESCRIPTION OF THE DRAWINGS

Some embodiments of a water-cooled container system according to the present disclosure are described with reference to accompanying drawings hereinafter.
FIG. 1 and FIG. 2 are schematic perspective views, taken front and rear side angles, of a water-cooled container system according to some embodiments of the present disclosure;
FIG. 3 is a front view of a water-cooled container system with panels removed according to some embodiments of the present disclosure;
FIG. 4 is a top view of a water-cooled container system with a top panel removed according to some embodiments of the present disclosure;
FIG. 5 is a perspective view of a water-cooled container system with panels removed according to some embodiments of the present disclosure;
FIG. 6 is a left side view of a water-cooled container system with panels removed according to some embodiments of the present disclosure; and
FIG. 7 and FIG. 8 are schematic perspective views of a water-cooled container system, taken front and rear side angles, according to some embodiments of the present disclosure.

Reference numerals and denotations thereof: 10-water-cooled container system; 10a-front surface; 10b-rear surface; 10c-first end surface; 10d-second end surface; 10e-top surface; 10f-bottom surface; 11-first space; 111-first main panel; 1111-entrance door; 1113-ventilation window; 112-second main panel; 1121-escape door; 113-end panel; 114-water barrier plate; 1141-notch; 1142-recess; 115-top panel; 1151-air outlet; 116-bottom panel; 12-second space; 121-connecting post; 122-reinforcing rib; 13-water cooling apparatus; 131-water cooling cabinet; 1311-first mounting space; 1313-second mounting space; 1315-base; 132-water inlet pipe; 1321-main water inlet pipe; 1323-branch water inlet pipe; 133-water outlet pipe; 1331-main water outlet pipe; 1333-branch water outlet pipe; 134-control device; 1341-water pump; 1343-deaeration tank; 1345-water replenishment tank; 14-power supply device; 141-power distribution cabinet; 143-PDU; 15-data processing device; 151-server; 153-network switch.

### DETAILED DESCRIPTION

The present disclosure is described with reference to some exemplary embodiments. However, the present disclosure is not limited to these exemplary embodiments. In the detailed description of the present disclosure, specific details are set forth. To avoid unnecessarily obscuring the substance of the present disclosure, well-known methods, procedures, processes, and components have not been described in detail.

Furthermore, it should be understood by persons of ordinary skill in the art that the drawings provided herein are for illustrative purposes only and are not necessarily drawn to scale.

Unless the context clearly requires otherwise, throughout this specification and the claims, the words "comprise," "contain," and the like are to be construed in an inclusive sense, as opposed to an exclusive or exhaustive sense, that is, in the sense of "including, but not limited to."

It should be noted that terms such as "first," "second," and the like are merely used for illustration purpose during the description of the present disclosure, and shall not be understood as indicating or implying relative importance. In addition, in the description of the present disclosure, the term "multiple," "more," or "a plurality of" refers to at least two unless otherwise specified.

Some embodiments of the present disclosure provide a water-cooled container system. The water-cooled container system includes a data processing device, a water cooling apparatus, and a power distribution cabinet. The water cooling apparatus is configured to accommodate the data processing device and to dissipate heat for the data processing device. The power supply device is at least configured to supply power to the data processing device.

The water cooling apparatus includes a water cooling cabinet, a water inlet pipe, a water outlet pipe, a control device, and a cooling device. The data processing device is accommodated in the water cooling cabinet. One end of each of the water inlet pipe and the water outlet pipe is connected to the water cooling cabinet, and the other end of the each of the water inlet pipe and the water outlet pipe is connected to the control device. The control device is configured to control water to flow from the water inlet pipe into the water cooling cabinet. The water absorbs heat generated by the data processing device during running, then flows out from the water outlet pipe, and is re-fed into the water inlet pipe after being cooled by the cooling device.

The water-cooled container system has a cuboid body, and a space enclosed by an outer contour of the water-cooled container system is divided by a water barrier plate having a notch into a first space and a second space. The control device is arranged in the first space. The water cooling cabinet and the power distribution cabinet are arranged in the second space, and the power distribution cabinet is arranged on a side of the water cooling cabinet away from the control device. The water inlet pipe and the water outlet pipe in the first space pass through the notch of the water barrier plate to enter the second space.

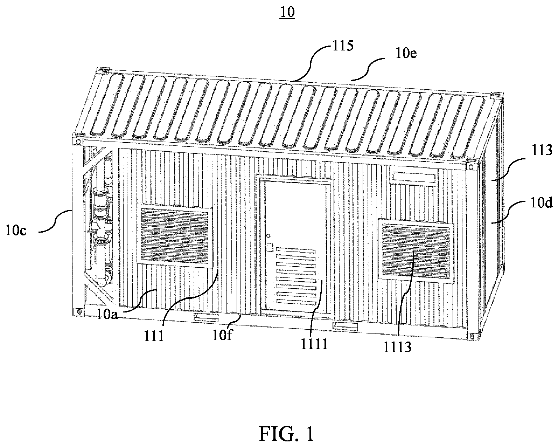

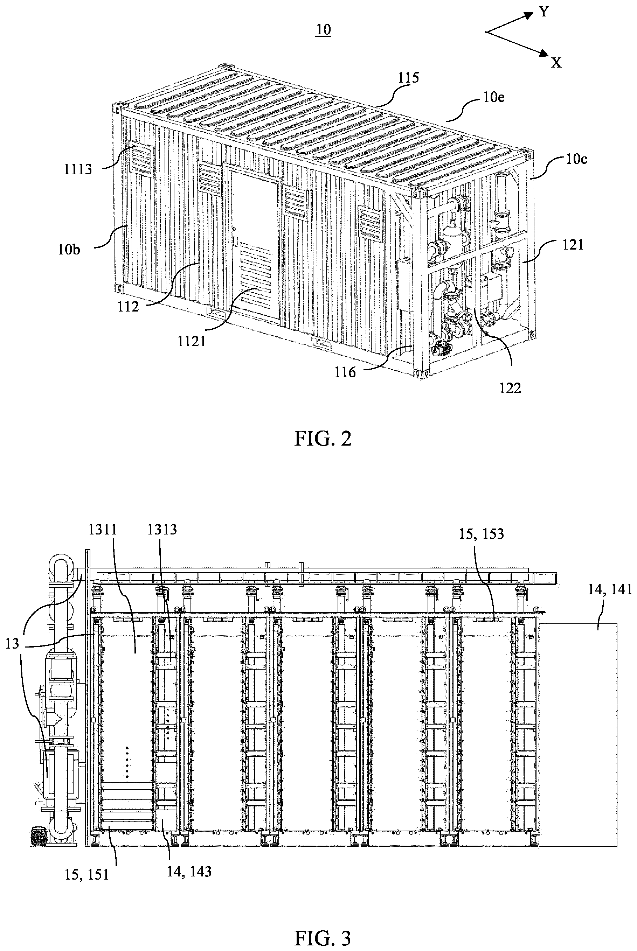

Referring to FIG. 1 and FIG. 2, some embodiments of the present disclosure provide a water-cooled container system 10. The water-cooled container system 10 may have standard container dimensions, for example, a 20-foot standard container or high cube container, a 40-foot standard container or high cube container, or any other dimensions, which may be determined according to actual needs.

The water-cooled container system 10 according to the present disclosure is generally rectangular (or box-shaped), which may be cube-shaped, cuboid-shaped (or rectangular parallelepiped-shaped), or substantially cube-shaped or cuboid-shaped; or may have other regular or irregular shapes. It is to be understood that, the shape of the water-cooled container system 10 according to the present disclosure refers to the shape of the space enclosed by the outer contour thereof.

In the present disclosure, the water-cooled container system 10 having a cuboid shape is taken as an example for description. The water-cooled container system 10 has a front surface 10a, a rear surface 10b, a first end surface 10c, a second end surface 10d, a top surface 10e, and a bottom surface 10f. The front surface 10a is opposite to the rear surface 10b, the first end surface 10c is opposite to the second end surface 10d, and the top surface 10e is opposite to the bottom surface 10f. To facilitate the description of relative positional relationships of various components/devices in the water-cooled container system 10, the above-described positional terms are used in the following description to describe these relative positional relationships. It is to be understood that positional terms such as the front surface 10a, the rear surface 10b, the top surface 10e, and the bottom surface 10f refer to relative positional relationships between components/devices, rather than absolute positional relationships.

Referring to FIG. 3, the water-cooled container system 10 includes a data processing device 15, a water cooling apparatus 13, and a power supply device 14. The water cooling apparatus 13 is configured to accommodate the data processing device 15 and dissipate heat for the data processing device 15. The power supply device 14 is at least configured to supply power to the data processing device 15. In some embodiments, the power supply device 14 is also configured to supply power to the water cooling apparatus 13.

In some embodiments, the power supply device 14 includes a power distribution cabinet 141 and PDUs 143 (FIG. 3 schematically illustrates only the power distribution cabinet 141 and some of the PDUs 143). The power distribution cabinet 141 is connected to an external power source to supply electrical energy. The PDUs 143 are electrically connected to the power distribution cabinet 141, facilitating the supply of electrical energy to the data processing device 15. At least some devices within the data processing device 15 may draw power from the PDUs 143, rather than being directly connected via cables to the power distribution cabinet 141 to draw power. In some embodiments, some components within the data processing device 15 may also draw power directly from the power distribution cabinet 141, with no need of drawing power through the PDUs 143.

In some embodiments, the power supply device 14 may not only supply power to the data processing device 15, but also supply power to the water cooling apparatus 13 through the power distribution cabinet 141 or the PDUs 143.

In some embodiments, the PDUs 143 in the power supply device 14 may be omitted, or in some embodiments, the PDUs 143 do not belong to the power supply device 14.

In some embodiments, the data processing device 15 includes servers 151 and network switches 153. The servers 151 are connected to the network switches 153 via cables. Signals supplied by the network switches 153 to the servers 151 include, but are not limited to, network signals. In the embodiments, the data processing device 15 includes a plurality of servers 151, and at least one network switch 153. It is to be understood that the numbers of servers 151 and network switches 153 are not limited and may be adjusted according to the data processing needs of the water-cooled container system 10. In some embodiments, the server 151 includes at least one hash board (i.e., computing board, not illustrated), with hundreds or even thousands of chips arranged thereon. The number of chips that are connected in series is greater than one hundred. It is to be understood that the number of chips on the hash board may be adjusted according to actual needs of computing power.

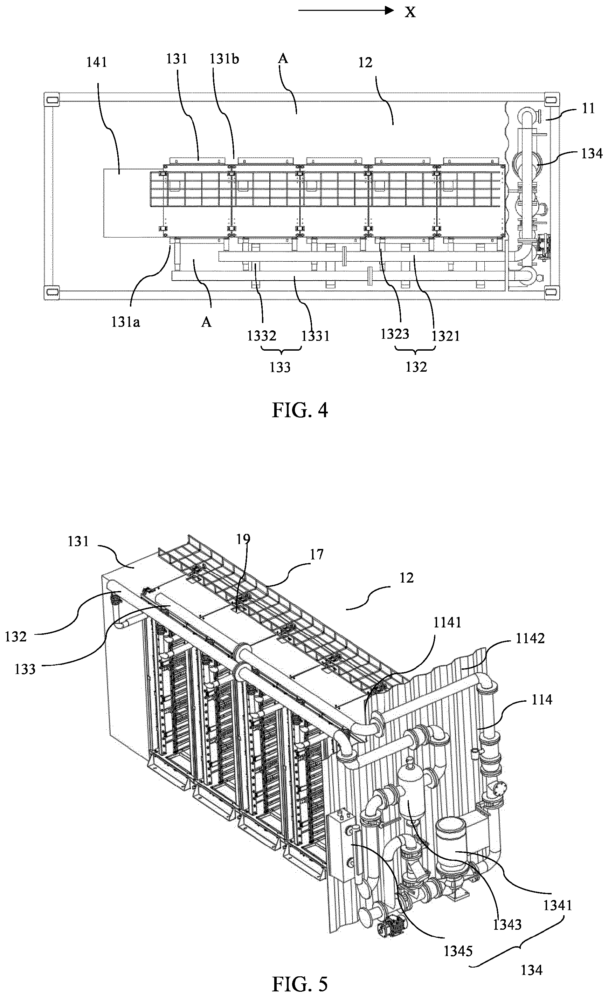

Referring to FIG. 3 and FIG. 4, the water cooling apparatus 13 includes a water cooling cabinet 131, a water inlet pipe 132, a water outlet pipe 133, a control device 134, and a cooling device (not illustrated). The data processing device 15 is accommodated in the water cooling cabinet 131. One end of each of the water inlet pipe 132 and the water outlet pipe 133 is connected to the water cooling cabinet 131, and the other end of the each of the water inlet pipe 132 and the water outlet pipe 133 is connected to the control device 134. The control device 134 is configured to control water to flow from the water inlet pipe 132 into the water cooling cabinet 131. The water absorbs heat generated by the data processing device 15 during operation, then flows out from the water outlet pipe 133, and is re-fed into the water inlet pipe 132 after being cooled by the cooling device.

It is to be understood that, in a case where the water in the water inlet pipe 132 is fed into the water cooling cabinet 131, the water may flow into a flow channel plate (not illustrated) arranged close to the hash board, and the water passes through the flow channel plate to thereby carry away heat generated by the hash board during operation.

Referring to FIG. 4 to FIG. 6, the water-cooled container system 10 has a cuboid body, and a space enclosed by an outer contour of the water-cooled container system 10 is divided by a water barrier plate 114 having a notch 1141 into a first space 11 and a second space 12. The control device 134 is arranged in the first space 11. The water cooling cabinet 131 and the power distribution cabinet 141 are arranged in the second space 12. The power distribution cabinet 141 is arranged on a side of the water cooling cabinet 131 away from the control device 134. The water inlet pipe 132 and the water outlet pipe 133 in the first space 11 pass through the notch 1141 of the water barrier plate 114 to enter the second space 12.

Although the data processing device 15 and the power distribution cabinet 141 is susceptible to water leakage, in the present disclosure, the water barrier plate 141 separates the water cooling cabinet 131 accommodating the data processing device 15 and the power distribution cabinet 141 from the control device 134 into different spaces, even though a fault occurs in the control device 134 and thus water is caused to flow out, the data processing device 15 and the power distribution cabinet 141 are not affected. In this way, the waterproof performance of the water-cooled container system 10 is improved, and the safety is greatly enhanced. Furthermore, because the power distribution cabinet 141 is arranged on a side of the water cooling cabinet 131 away from the control device 134, and the power distribution cabinet 141 and the control device 134 are disposed at opposite ends of the water cooling cabinet 131 respectively, gravity distribution of the water-cooled container system 10 is uniform, thereby facilitating hoisting, transportation, and stable placement.

The power distribution cabinet 141 is away from the control device 134, that is, the power distribution cabinet 141 is completely outside the water paths. Even though leakage occurs, the likelihood that power distribution cabinet 141 is affected is significantly reduced.

In some embodiments, a distance between the power distribution cabinet 141 and the control device 134 is greater than 4 meters, such that the power distribution cabinet 141 is better ensured to be far away from a water source, and hence safety during use of electricity is ensured.

In some embodiments, a water barrier plate 114 with a notch 1141 may also be arranged between the power distribution cabinet 141 and the water cooling cabinet 131. The notch 1141 allows for the passage of cables. The water barrier plate 114 separates the water cooling cabinet 131 from the power distribution cabinet 141, thereby further ensuring the electrical safety of the power distribution cabinet 141.

Still referring to FIG. 4 to FIG. 6, in some embodiments, a recess 1142 extending in a vertical direction is arranged on the water barrier plate 114. The recess 1142 extends from a top end of the water barrier plate to a bottom end thereof. Where water leakage occurs to the control device 134, water flowing on the water barrier plate 114 may be quickly guided by the water barrier plate 114 to the bottom thereof.

In some embodiments, the notch 1141 is arranged in a corner of a top portion of the water barrier plate 114. This may reduce the possibility that water flows from the first space 11 into the second space 12.

In some embodiments, a cross-section of the water barrier plate 114 is wave-shaped.

In some embodiments, the control device 134 includes a water pump 1341, a deaeration tank 1343, and a water replenishment tank 1345. The water pump 1341 is arranged on a pipeline of the water inlet pipe 132, and the deaeration tank 1343 and the water replenishment tank 1345 are arranged on a pipeline of the water outlet pipe 133. The deaeration tank 1343 may timely discharge air from the water circulation system to prevent air from affecting the heat dissipation efficiency, and the water replenishment tank 1345 timely replenishes water to ensure that the water in the water inlet pipe 132 and the water outlet pipe 133 is sufficient.

In some embodiments, the cooling device may be any device capable of cooling water, such as a cooling tower.

Referring back to FIG. 1 and FIG. 2, in some embodiments, the outer contour of the water-cooled container system is defined by a first main panel 111, a second main panel 112, an end panel 113, a top panel 115, a bottom panel 116, connecting posts 121, and reinforcing ribs 122. The first main panel 111 and the second main panel 112 are oppositely arranged, and outer side surfaces thereof are the front surface 10a and the rear surface 10b of the water-cooled container system respectively. The top panel 115 and the bottom panel 116 are oppositely arranged, and outer surfaces thereof are the top surface 10e and the bottom surface 10f of the water-cooled container system respectively. The end panel 113 is disposed at one end of the water-cooled container system, and an outer side surface thereof is the first end surface 10c of the water-cooled container system. The connecting posts 121 and the reinforcing ribs 122 are disposed at the other end of the water-cooled container system, and an end surface defined thereby is the second end surface 10d of the water-cooled container system (it is to be understood that the term "end surface" merely refers to a relative position, which may be formed by a surface of a physical component, or may partially be a non-physical component surface, i.e., a space).

The first main panel 111, the second main panel 112, the end panel 113, the top panel 115, the bottom panel 116, the connecting posts 121, and the reinforcing ribs 122 are connected to enclose an internal space having a cuboid shape. Each of the first space 11 and the second space 12 divided by the water barrier plate 114 also has a cuboid body shape. The second space 12 is relatively sealed and is cooperatively enclosed by a plurality of panels (including the first main panel 111, the second main panel 112, the end panel 113, and portions of the top panel 115 and the bottom panel 116) and the water barrier plate 114. A top portion and a bottom portion of the first space 11 are the top panel 115 and the bottom panel 116 respectively. On sides of the front surface 10a, the rear surface 10b, and the second end surface 10d of the water-cooled container system 10, the first space 11 has an openwork structure or an open structure. It is to be understood that the second space 12 is a space defined by portions of the top panel 115 and the bottom panel 116, the connecting posts 121, and the reinforcing ribs 122. In a case where product strength requirements are met, the reinforcing ribs 122 may be omitted, meaning that three sides of the first space 11 have an open structure. In a case where the reinforcing ribs 122 are present, three sides of the first space 11 have an open structure. The design of the open structure or the openwork structure allows heat generated by the control device 134 to be timely exchanged with external air, thereby timely dissipating the heat.

In some embodiments, the first space 11 may also be configured as a two-sided openwork structure or an open structure.

Referring collectively to FIG. 4, in some embodiments, the water-cooled container system 10 includes, in a direction perpendicular to a first direction (i.e., Y direction), a first main panel 111 and a second main panel 112 that are opposite to each other. An aisle A is arranged between the water cooling cabinet group and the first main panel 111, and an aisle A is also arranged between the water cooling cabinet group and the second main panel 112, to facilitate operation by personnels. Doors are arranged in both the first main panel 111 and the second main panel 112. Specifically, an entrance door 1111 is arranged in the first main panel 111, and an escape door 1121 is arranged in the second main panel 112.

In some embodiments, ventilation windows 1113 are further arranged in the first main panel 111 and the second main panel 112.

Referring to FIG. 4, a plurality of the water cooling cabinets 131 are provided, and the water cooling cabinets 131 are closely arranged along a first direction (X direction). Each of the water cooling cabinets 131 includes, in a second direction, a first side 131a and a second side 131b that are opposite to each other. The water inlet pipe 132 and the water outlet pipe 133 are connected to each of the water cooling cabinets 131 from the first side 131a, and cables from the power distribution cabinet 141 enter each of the water cooling cabinets 131 from the second side 131b to supply power to the data processing device 15. Since the electrical circuits and the water paths are disposed on opposite sides of the water cooling cabinets 131, the electrical circuits and the water paths are kept distant from each other, which prevents water leakage from affecting the electrical circuits.

In some embodiments, the water inlet pipe 132 includes a main water inlet pipe 1321 and branch water inlet pipes 1323. The main water inlet pipe 1321 conveys water to the water cooling cabinets 131 through the branch water inlet pipes 1323. The water outlet pipe 133 includes a main water outlet pipe 1331 and branch water outlet pipes 1333. The water cooling cabinets 131 convey water into the main water outlet pipe 1331 via the branch water outlet pipes 1333. In some embodiments, the main water inlet pipe 1321 and the main water outlet pipe 1331 extend along the first direction and are staggered from the water cooling cabinet 131 in the second direction. That is, a distance in the second direction is present between the main water inlet pipe 1321 and the main water outlet pipe 1331, and the water cooling cabinet 131. Thus, even though leakage occurs, water flow is likely to directly enter the water cooling cabinet 131.

In some embodiments, a cable rack 17 is arranged at a top portion of an end of the water cooling cabinet 131 that is away from the water inlet pipe 132 or the water outlet pipe 133 in the second direction. Cable routing holes 19 are arranged in the top portion of the water cooling cabinet 131. Cables from the power distribution cabinet 141 to the data processing system 15 may be placed on the cable rack 17 and enter the water cooling cabinet 131 through the cable routing holes 19 in the top portion of the water cooling cabinet 131. Since the cable rack 17 is away from the water inlet pipe 132 or the water outlet pipe 133 in a second direction, its susceptibility to water leakage is also significantly reduced.

In some embodiments, a plurality of water cooling cabinets 131 are provided, which are closely arranged along a first direction. It is to be understood that the close arrangement means that outer side walls of adjacent water cooling cabinets 131 are abutted against each other, or gaps between the cabinets are very small, such that these cabinets tend to be in an abutting state.

Referring to FIG. 3, in some embodiments, the water cooling cabinet 131 includes a first mounting space 1311 and a second mounting space 1313 that are juxtaposed in a horizontal direction. The first mounting space 1311 is configured to accommodate the servers 151, and the second mounting space 1313 is configured to secure the PDUs 143. In the first mounting space 1311, the servers 151 are stacked in a vertical direction. It is to be understood that a gap is present between adjacent servers 151 to facilitate heat dissipation. In the second mounting space 1313, the PDUs 143 are stacked in a vertical direction. It is to be understood that a gap is present between adjacent PDUs 143 to facilitate heat dissipation.

The first mounting space 1311 and the second mounting space 1313 are juxtaposed in the horizontal direction, such that the PDUs 143 are arranged on one side of each of the servers 151, thereby facilitating wiring. In the related arts, the water cooling cabinets accommodating servers are closely arranged, and in a first direction, an internal space of the water cooling cabinet 131 is fully occupied by the servers, consequently leading to a very short distance between servers in adjacent water cooling cabinets, concentrated heat sources, and a rapid rise in ambient temperature. However, in the present disclosure, the first mounting space 1311 for accommodating the servers 151 and the second mounting space 1313 for accommodating the PDUs are juxtaposed, such that a relatively larger distance is present between the servers 151 in adjacent water cooling cabinets 131, and thus heat is not easily concentrated. This, while ensuring convenient wiring, also takes the heat dissipation effect into account. Furthermore, the first mounting space 1311 and the second mounting space 1313 are in communication with each other in the horizontal direction. This configuration increases air convection between the mounting spaces, thereby further promoting the dissipation of heat from the servers 151.

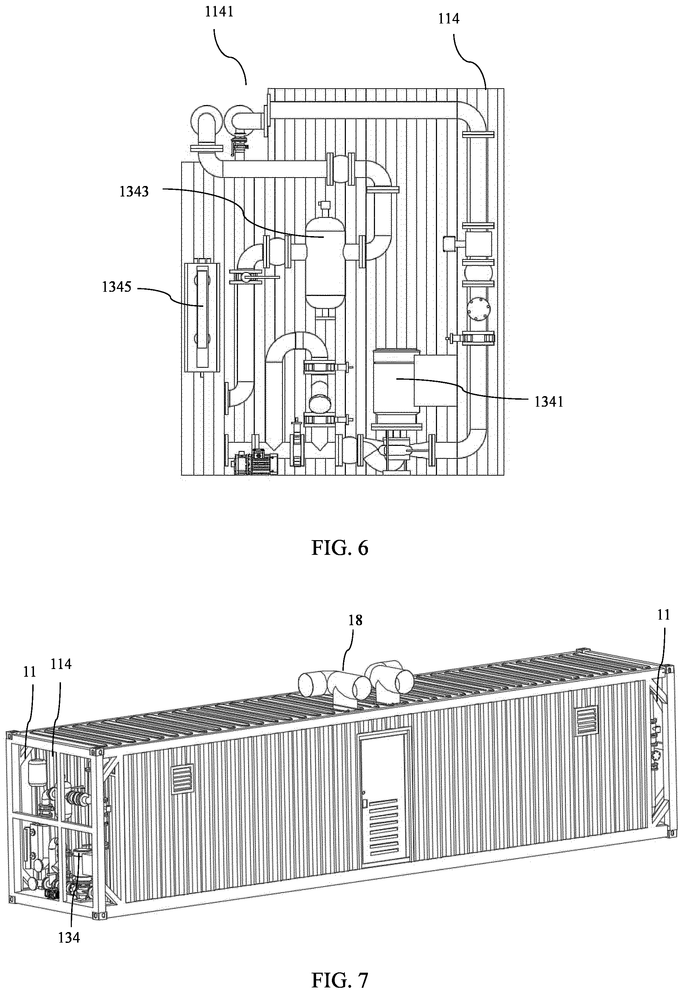

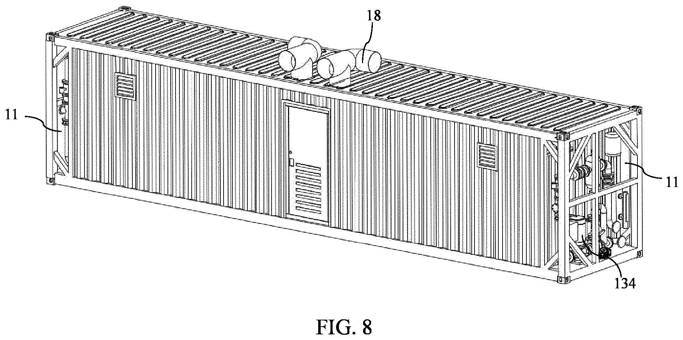

Referring to FIG. 7 and FIG. 8, the present disclosure further provides an embodiment wherein a plurality of water cooling cabinets 131 are provided, and the water cooling cabinets 131 are closely arranged along a first direction to form a water cooling cabinet group. A plurality of water cooling cabinet groups are accommodated in the second space 12, and the plurality of water cooling cabinet groups are arranged along the first direction. The power distribution cabinet 141 is arranged at a middle position of the plurality of water cooling cabinet groups.

The space enclosed by the outer contour of the water-cooled container system 10 is divided by two water barrier plates 114, each having a notch 1141, into two first spaces 11 and one second space 12. The two first spaces 11 are disposed at opposite ends of the second space 12, a control device 134 is arranged in each of the two first spaces 11, and the control device 134 conveys water into the water cooling cabinet 131 via the water inlet pipe 132 and the water outlet pipe 133.

In some embodiments, two water cooling cabinet groups are provided, and the power distribution cabinet 141 is arranged therebetween, which not only avoids the risk of water leakage on water paths, but also facilitates shortening of wiring. A control device 134 is arranged at an end of each of the water cooling cabinet groups away from the power distribution cabinet 141, and a space where the control device 134 is disposed and a space where the power distribution cabinet 141 and the water cooling cabinet groups are disposed are both separated by a water barrier plate 114. While improving safety, because the entire water-cooled container system 10 is symmetrically designed with respect to a centerline thereof in the first direction as an axis of symmetry, it is conducive to improving the assembly efficiency, and facilitating hoisting, transportation, and stable placement.

In some embodiments, the water-cooled container system 10 is symmetrically designed with respect to the centerline thereof in the first direction as the axis of symmetry.

In some embodiments, a ventilation device 18 may be arranged at a top portion of the water-cooled container system 10.

A person skilled in the art would understand that the above technical solutions may be freely combined and superimposed as long as no conflicts exist.

It should be understood that the above embodiments are only exemplary, and construe no limitations. Under the circumstance of not departing from the basic principles of the present disclosure, various obvious or equivalent modifications or substitutions that persons skilled in the art may derive to the above-described details are all included within the scope of the claims of the present disclosure.

## Claims

1. A water-cooled container system, comprising: a data processing device, a water cooling apparatus, a power supply device, and a power distribution cabinet, wherein the water cooling apparatus is configured to accommodate the data processing device and to dissipate heat for the data processing device, and the power supply device is at least configured to supply power to the data processing device;
wherein the water cooling apparatus comprises a water cooling cabinet, a water inlet pipe, a water outlet pipe, a control device, and a cooling device; the data processing device is accommodated in the water cooling cabinet, one end of each of the water inlet pipe and the water outlet pipe is connected to the water cooling cabinet, and the other end of the each of the water inlet pipe and the water outlet pipe is connected to the control device; and the control device is configured to control water to flow from the water inlet pipe into the water cooling cabinet, wherein the water absorbs heat generated by the data processing device during running, then flows out from the water outlet pipe, and is re-fed into the water inlet pipe after being cooled by the cooling device; and
wherein the water-cooled container system has a cuboid body, and a space enclosed by an outer contour of the water-cooled container system is divided by a water barrier plate having a notch into a first space and a second space; wherein the control device is arranged in the first space; the water cooling cabinet and the power distribution cabinet are arranged in the second space, and the power distribution cabinet is arranged on a side of the water cooling cabinet away from the control device; and the water inlet pipe and the water outlet pipe in the first space pass through the notch of the water barrier plate to enter the second space.

2. The water-cooled container system according to claim 1, wherein
the notch is arranged in a corner of a top portion of the water barrier plate;
a recess extending in a vertical direction is arranged in the water barrier plate; and
a cross-section of the water barrier plate is wave-shaped, and a distance between the power distribution cabinet and the control device is greater than 4 meters.

3. The water-cooled container system according to claim 1, wherein
each of the first space and the second space has a cuboid body shape;
the second space is relatively sealed and is cooperatively enclosed by a plurality of panels and the water barrier plate; and
a top panel and a bottom panel are respectively arranged at a top portion and a bottom portion of the first space, and the first space has a two-sided openwork structure, or a three-sided openwork structure, or an open structure.

4. The water-cooled container system according to claim 1, wherein a plurality of the water cooling cabinets are provided, and the water cooling cabinets are closely arranged along a first direction;
wherein each of the water cooling cabinets comprises, in a second direction, a first side and a second side that are opposite to each other, the water inlet pipe and the water outlet pipe are connected to each of the water cooling cabinets from the first side, and wirings from the power distribution cabinet enter each of the water cooling cabinets from the second side to supply power to the data processing device;
wherein the second direction is perpendicular to the first direction.

5. The water-cooled container system according to claim 1, wherein a plurality of the water cooling cabinets are provided and are arranged along a first direction; and the water-cooled container system is symmetrically designed with respect to a centerline in the first direction as an axis of symmetry.

6. The water-cooled container system according to claim 1, wherein
a plurality of the water cooling cabinets are provided, and the water cooling cabinets are closely arranged along a first direction to form a water cooling cabinet group;
a plurality of water cooling cabinet groups are accommodated in the second space, wherein the plurality of water cooling cabinet groups are arranged along the first direction, and the power distribution cabinet is arranged at a middle position among the plurality of water cooling cabinet groups; and
the space enclosed by the outer contour of the water-cooled container system is divided by two of the water barrier plates having notches into two said first spaces and the second space, wherein the two first spaces are disposed at opposite ends of the second space, the control device is arranged in each of the two first spaces, and the control device is configured to control water to be conveyed to the water cooling cabinets via the water inlet pipe and the water outlet pipe.

7. The water-cooled container system according to claim 1, wherein
a plurality of the water cooling cabinets are provided, and the water cooling cabinets are closely arranged along a first direction; and
the water inlet pipe comprises a main water inlet pipe and branch water inlet pipes, wherein the main water inlet pipe is configured to convey water to each of the water cooling cabinets via the branch water inlet pipes; and the water outlet pipe comprises a main water outlet pipe and branch water outlet pipes, wherein each of the water cooling cabinets is configured to convey water to the main water outlet pipe via the branch water outlet pipes;
wherein the main water inlet pipe and the main water outlet pipe extend along the first direction, and the main water inlet pipe and the main water outlet pipe are offset from the water cooling cabinets in a second direction; and
wherein a cable rack is arranged on a top portion of an end of each of the water cooling cabinets away from the water inlet pipe or the water outlet pipe in the second direction, and a cable routing hole is arranged in a top portion of the each of the water cooling cabinets;
wherein the first direction is perpendicular to the second direction.

8. The water-cooled container system according to claim 1, wherein the control device comprises a water pump, a deaeration tank, and a water replenishment tank, wherein the water pump is arranged on a pipeline of the water inlet pipe, and the deaeration tank and the water replenishment tank are arranged on a pipeline of the water outlet pipe.

9. The water-cooled container system according to claim 1, wherein
the data processing device comprises servers and network switches; wherein a number of chips connected in series on a hash board included in each of the servers is greater than one hundred;
the water-cooled container system further comprises power distribution units (PDUs) for power supply, wherein the PDUs are connected to the power distribution cabinet; and
the water cooling cabinet comprises a first mounting space and a second mounting space juxtaposed in a horizontal direction, a plurality of the servers are stacked and secured in the first mounting space, and the PDUs are secured in the second mounting space;
wherein the PDUs are arranged on one side of each of the servers, and the first mounting space and the second mounting space are in communication in the horizontal direction.

10. The water-cooled container system according to claim 1, wherein
a plurality of the water cooling cabinets are provided, and the water cooling cabinets are closely arranged along a first direction to form a water cooling cabinet group; and
the water-cooled container system comprises, in a direction perpendicular to the first direction, a first main panel and a second main panel that are opposite to each other, wherein and an aisle is arranged between the water cooling cabinet group and the first main panel, and an aisle is arranged between the water cooling cabinet group and the second main panel;
wherein a door is arranged in each of the first main panel and the second main panel.
